# EUROPEAN PATENT APPLICATION

(11) **EP 2 624 310 A1**
(43) Date of publication of application: **07.08.2013**
(21) Application number: 11829045.1
(22) Date of filing: 26.09.2011
(51) Int. Cl.: H01L 31/042

(54) **SOLAR CELL MODULE**

(30) Priority: 29.09.2010 JP 2010219308
(71) Applicant: Hitachi Chemical Company, Ltd., Chiyoda-ku Tokyo 100-6606 (JP)
(72) Inventor: HAYASHI Hiroki, Tsukuba-shi Ibaraki 300-4247 (JP); KATOGI Shigeki, Tsukuba-shi Ibaraki 300-4247 (JP); NATORI Michiko, Tsukuba-shi Ibaraki 300-4247 (JP); SUKATA Shinichirou, Tsukuba-shi Ibaraki 300-4247 (JP); MOMOZAKI Aya, Tsukuba-shi Ibaraki 300-4247 (JP)
(74) Representative: Albrecht, Thomas
(86) International application number: PCT/JP2011/071914
(87) International publication number: WO 2012/043491

(57) **Abstract**

It is an object of the present invention to provide a solar cell module excellent in reliability that can prevent yield decrease in the manufacture of a solar cell module, and, in addition, sufficiently maintain the characteristics of the solar battery even after a temperature cycle test. The present invention provides a solar cell module comprising a connection structure in which a plurality of solar cells each having electrodes on both surfaces are electrically connected to each other by a wiring member, wherein the connection structure includes a metal portion prepared by melting of a metal having a melting temperature of 200°C or less, electrically connecting the electrode to the wiring member, and a resin portion adhering the electrode to the wiring member.

## Description

### Technical Field

The present invention relates to a solar cell module.

### Background Art

As means for solving global warming and fossil energy depletion problems that become serious, solar batteries, which are power generation systems using sunlight, are noted. Currently, a mainstream solar battery has a structure in which solar cells in which electrodes are formed on a monocrystalline or polycrystalline Si wafer are connected in series or in parallel by metal wiring members. Generally, solder, which shows good conductivity and is inexpensive, has been used for the connection of the electrodes of solar cells to metal wiring members (Patent Literature 1). Recently, considering environmental problems, a method of coating copper wires, which are wiring members, with Sn-Ag-Cu solder comprising no Pb, and performing heating to not less than the melting temperature of the solder to connect the electrodes of solar cells to wiring members has been known (Patent Literatures 1 and 2).

But, in this method, heating at not less than 260°C, which is more than the melting temperature of the Sn-Ag-Cu solder used, is required, and therefore, the deterioration of the characteristics of the solar cells, and the warpage or fracture of the solar cells occurring to decrease yield have been problems.

On the other hand, the use of conductive adhesives in which electrical connection is possible at lower temperature has been proposed (Patent Literatures 3 to 6). These conductive adhesives are compositions in which metal particles typified by silver particles are mixed and dispersed in a thermosetting resin, and electrical connection is exhibited by the metal particles being in physical contact with the electrodes of solar cells and wiring members.

### Citation List

### Patent Literature

Patent Literature 1: Japanese Patent Application Laid-Open Publication No. 2002-263880
Patent Literature 2: Japanese Patent Application Laid-Open Publication No. 2004-204256
Patent Literature 3: Japanese Patent Application Laid-Open Publication No. 8-330615
Patent Literature 4: Japanese Patent Application Laid-Open Publication No. 2003-133570
Patent Literature 5: Japanese Patent Application Laid-Open Publication No. 2005-243935
Patent Literature 6: Japanese Patent Application Laid-Open Publication No. 2007-265635

### Summary of Invention

### Technical Problem

However, even with the conductive adhesives described in the above Patent Literatures 3 to 6, sufficient connection characteristics are not always obtained. Specifically, it has become clear from the study of the present inventors that when a solar cell module fabricated using a conventional conductive adhesive comprising silver particles and a thermosetting resin is exposed to a temperature cycle test, its characteristics decrease.

In view of the above problem that conventional art has, it is an object of the present invention to provide a solar cell module excellent in reliability that can prevent yield decrease in the manufacture of a solar cell module, and, in addition, sufficiently maintain the characteristics of the solar battery even after a temperature cycle test.

### Solution to Problem

In order to solve the above problem, the present invention provides a solar cell module comprising a connection structure in which a plurality of solar cells each comprising electrodes on both surfaces are electrically connected to each other by a wiring member, wherein the connection structure includes a metal portion prepared by melting of a metal having a melting temperature of 200°C or less, electrically connecting the electrode to the wiring member, and a resin portion adhering the electrode to the wiring member.

In the solar cell module of the present invention, by having the above constitution, yield decrease in manufacture is less likely to occur, and, in addition, the characteristics of the solar battery can be sufficiently maintained even after a temperature cycle test.

In other words, the solar cell module of the present invention has a connection structure in which the connection of the wiring member to the electrode is possible by heating at 200°C or less. Thus, in the solar cell module of the present invention, compared with a solar cell module fabricated under the heating condition of 260°C or more using Sn-Ag-Cu-based solder, the deterioration of the characteristics of the solar cells, the warpage or fracture of the solar cells, and the like are less likely to occur, and a decrease in yield can be suppressed.

In addition, the solar cell module of the present invention comprises a connection structure in which a wide and strong conductive path formed by the melting of the metal having a melting temperature of 200°C or less is formed between the electrode of the solar cell and the wiring member, and the electrode and the wiring member are adhered to each other by the resin portion. Thus, it is considered that resistance to thermal strain in a temperature cycle test is sufficiently obtained, and the characteristics of the solar battery can be sufficiently maintained.

In the solar cell module of the present invention, it is preferred that the above wiring member is strip-shaped, and when the above metal portion and the above resin portion are viewed in a cross section orthogonal to a direction in which the wiring member extends, the metal portion is positioned to connect a central portion of the wiring member to a central portion of the electrode, and the resin portion is positioned to adhere an outside of the above central portion of the wiring member to an outside of the above central portion of the electrode.

According to the solar cell module comprising such a structure, connection by the above metal portion is more strongly reinforced by the above resin portion, and therefore, the resistance of the solar battery to temperature cycles can be further improved. In addition, in the above solar cell module, the above metal portion is less likely to be affected by external moisture and the like due to the protection of the above resin portion, and the above solar cell module can also be excellent in connection reliability at high temperature and high humidity conditions (85°C/85% RH).

In addition, it is preferred that the above metal portion and the above resin portion are formed by heating a conductive adhesive comprising (A) conductive particles comprising a metal having a melting temperature of 200°C or less, (B) a thermosetting resin, and (C) a flux activator, at a temperature at which the above conductive particles melt, in a state in which the above conductive adhesive is interposed between the electrode and the wiring member before connection and adhesion.

The metal portion formed by the above step can be one having few defects in a conductive path because the conductive particles are more reliably integrated with each other by the flux activator. Thus, effects, such as power generation efficiency improvement accompanying low resistance, can be obtained. In addition, the resin portion formed by the above step can be excellent in adhesiveness and heat resistance, and therefore, the reliability of the solar cell module can be further improved.

Further, it is preferred that the above metal portion and the above resin portion are formed by performing the above heating while applying pressure to the electrode and the wiring member before connection and adhesion in a direction in which the electrode and the wiring member are opposed to each other.

### Advantageous Effects of Invention

According to the present invention, it is possible to provide a solar cell module excellent in reliability that can prevent yield decrease in the manufacture of a solar cell module, and, in addition, sufficiently maintain the characteristics of the solar battery even after a temperature cycle test.

### Brief Description of Drawings

[Figure 1] Figure 1 is a schematic diagram showing one embodiment of the solar cell module of the present invention.
[Figure 2] Figure 2 is a cross-sectional view taken along line II-II in Figure 1.
[Figure 3] Figure 3 is an enlarged view of a region shown by a frame 24 in Figure 2.
[Figure 4] Figure 4 is a schematic diagram showing one embodiment of a method for manufacturing the solar cell module of the present invention.
[Figure 5] Figure 5 is a schematic diagram showing one embodiment of the method for manufacturing the solar cell module of the present invention.
[Figure 6] Figure 6 is a schematic diagram for explaining another embodiment of the method for manufacturing the solar cell module of the present invention.

### Description of Embodiments

Embodiments of the present invention will be described in detail below referring to the drawings, but the present invention is not limited to these. Like reference numerals in the drawings indicate like parts or corresponding parts.

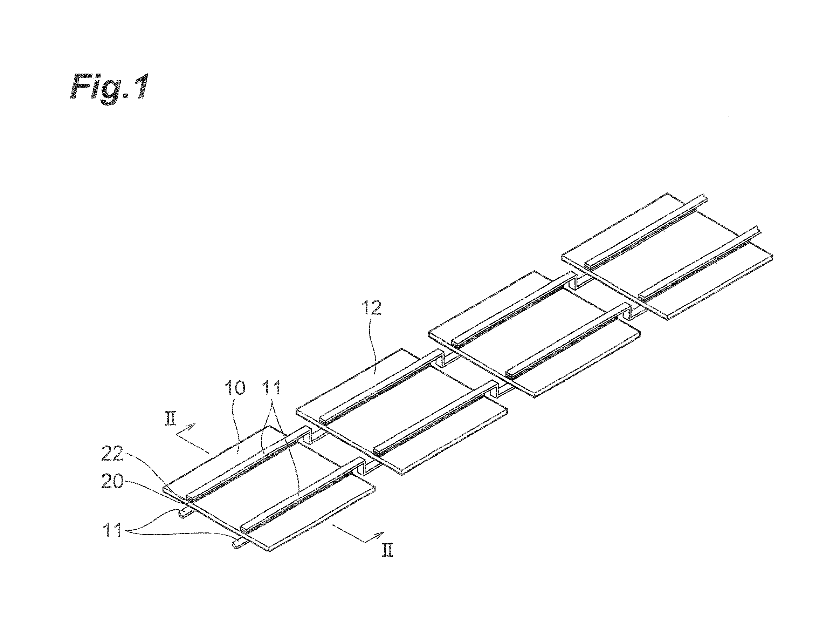

Figure 1 is a schematic diagram showing the main part of one embodiment of the solar cell module of the present invention. The solar cell module shown in Figure 1 has a connection structure in which a plurality of solar cells each having electrodes on both surfaces are electrically connected to each other by wiring members. In the solar cell module in this embodiment, the front electrodes of a solar cell 10 and one sides of wiring members 11 are electrically connected by a conductive adhesive according to the present invention, and further, the other sides of the wiring members 11 are connected to the back electrodes of an adjacent solar cell 12, and using such a connection structure as a repeating unit, the solar cell module is formed of several tens of the units. Finally, by performing laminate sealing in which a sealing resin is disposed on the light-receiving surface side of these units, a glass substrate is further disposed on the sealing resin, the sealing resin is disposed on a back side, a protective film is further disposed on the sealing resin, these are heated, and pressure is applied to these as required, and further supporting an outer peripheral portion by an aluminum frame, the solar cell module is provided. For the sealing resin, generally, a vinyl acetate copolymer (EVA) is used. For the protective film, generally, a weather-resistant film, such as Tedlar manufactured by DuPont, is used.

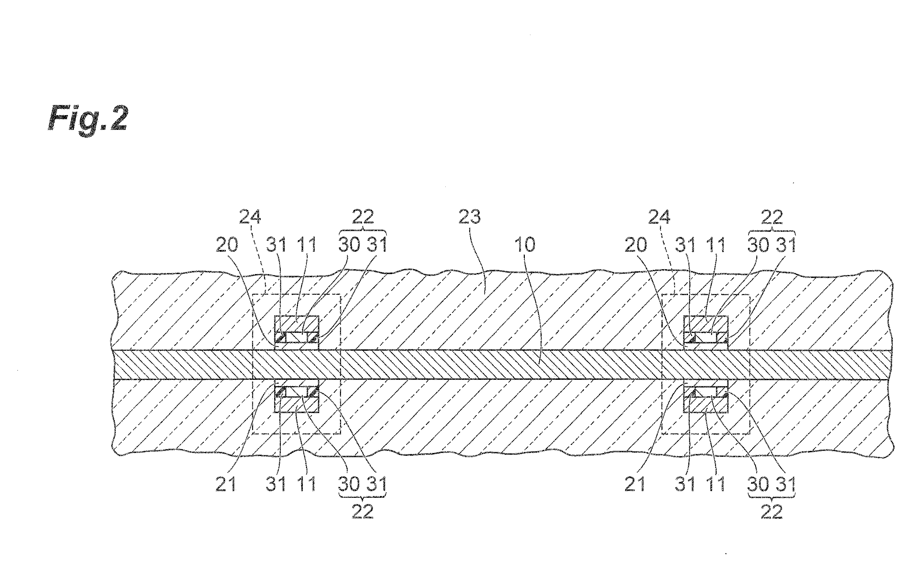

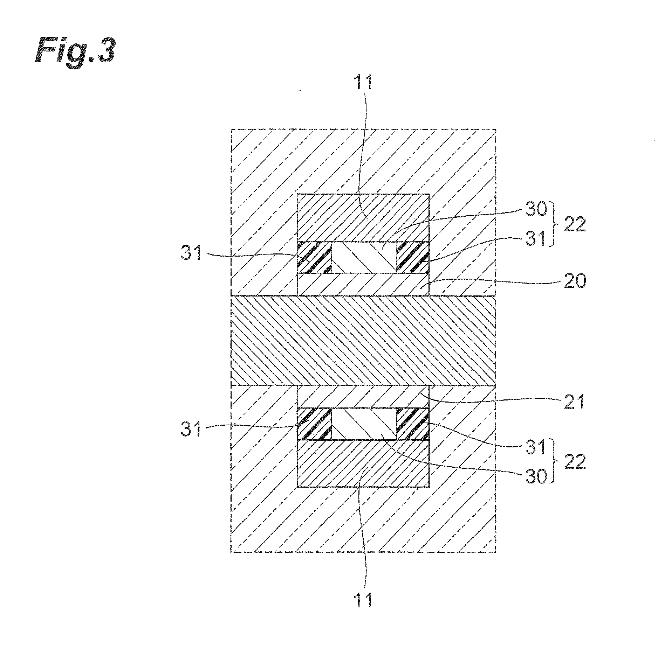

Figure 2 is a cross-sectional view taken along line II-II in Figure 1, and the connection structure is viewed in a cross section orthogonal to a direction in which the strip-shaped wiring members 11 extend. Figure 3 is an enlarged view of a region shown by a frame 24 in Figure 2, and specifically shows one example of the connection structure according to the present invention.

The connection structure of the solar cell module in this embodiment includes a joining portion 22 composed of a metal portion 30 prepared by melting of a metal having a melting temperature of 200°C or less, electrically connecting a front electrode 20 or a back electrode 21 to the wiring member 11, and resin portions31 adhering the front electrode 20 or the back electrode 21 to the wiring member 11. In this embodiment, when the above metal portion 30 and the above resin portions 31 are viewed in a cross section orthogonal to a direction in which the wiring member 11 extends, the metal portion 30 is positioned to connect the central portion of the wiring member 11 to the central portion of the front electrode 20 or the back electrode 21, and the resin portions 31 are positioned to adhere the outside of the above central portion of the wiring member 11 to the outside of the above central portion of the front electrode 20 or the back electrode 21. In addition, the whole of this connection structure is sealed with EVA 23, which is a sealing resin.

The above central portion of the wiring member 11 and the outside of the above central portion also mean the central portion and both end portions of the wiring member in a width direction (transverse direction), and the above central portion of the front electrode 20 or the back electrode 21 and the outside of the above central portion also mean the central portion and both end portions of the electrode in a width direction (transverse direction).

In the joining portion 22 according to this embodiment, the central portion of the front electrode 20 and the central portion of the wiring member 11 are joined by the melting of the metal having a melting temperature of 200°C or less, and further, in the peripheral portions of the molten metal, the front electrode 20 and the wiring member 11 are adhered to each other by an adhesive made of a resin. In addition, also in the joining portion on a back side, similarly, the central portion of the back electrode 21 and the central portion of the wiring member 11 are joined by the melting of the metal having a melting temperature of 200°C or less, and further, in the peripheral portions of the molten metal, the back electrode 21 and the wiring member 11 are adhered to each other by the adhesive made of a resin.

In this embodiment, from the viewpoint of conductivity, it is preferred that a region of 5 to 80% of the width of the wiring member and a region of 5 to 80% of the width of the front electrode or the back electrode are connected by the metal portion.

In addition, in the joining portion 22 of the solar cell module in this embodiment, when the above metal portion 30 and the above resin portions 31 are viewed in a cross section orthogonal to the direction in which the wiring member 11 extends, the ratio of the area of the metal portion to the area of the resin portions [the metal portion]/[the resin portions] is preferably 5/95 to 80/20, more preferably 20/80 to 70/30. If this ratio is less than 5/95, that is, the amount of the metal portion is small, there is a tendency that electrical resistance increases, and if this ratio is more than 80/20, that is, the amount of the metal portion is large, there is a tendency that temperature cycle resistance decreases.

By including the above joining portion, the solar cell module in this embodiment can be manufactured by connection at a low temperature of 200°C or less, and therefore, compared with conventional solar cell modules fabricated by making connections at 260°C or more using Sn-Ag-Cu-based solder, the deterioration of the characteristics of the solar cells, yield decrease due to the warpage or fracture of the solar cells, and the like can be suppressed.

In addition, it is alleged that a conductive adhesive comprising silver particles can generally adhere at 150 to 200°C and exhibit conductivity. But, in a solar cell module fabricated by making connections using this silver-based conductive adhesive, a conductive path in a connection structure between an electrode of a solar cell and a wiring member is formed by a relatively narrow and fragile path due to the contact of the particles with each other. On the other hand, in the solar cell module in this embodiment, the metal portion prepared by the melting of a metal having a melting temperature of 200°C or less can form a wide and strong conductive path, and therefore, compared with the above solar cell module, power generation efficiency improvement accompanying low resistance, and an improvement in resistance to thermal strain in a temperature cycle test can be promoted.

It is alleged that a metal having a melting temperature of 200°C or less is hard and fragile compared with Sn-Ag-Cu-based solder, which is a conventional connection material, because generally, bismuth, zinc, or the like is contained. Therefore, when the metal having a melting temperature of 200°C or less is simply melted to join the electrodes of a solar cell to wiring members, the characteristics of a solar battery cannot be sufficiently maintained after a temperature cycle test. On the other hand, in the solar cell module in this embodiment, in addition to the electrodes of the solar cell and the wiring members being joined by the molten metal, the peripheral portions of the joining are adhered by the adhesive made of a resin, and therefore, fragility common to metals having a melting temperature of 200°C or less can be eliminated, and an improvement in resistance to thermal strain in a temperature cycle test can be promoted.

The joining portion 22 according to this embodiment can be formed by heating a conductive adhesive comprising (A) conductive particles comprising a metal in which a melting temperature is 200°C or less, (B) a thermosetting resin, and (C) a flux activator, at a temperature at which the above conductive particles melt, in a state in which the above conductive adhesive is interposed between the front electrode 20 or the back electrode 21 and the wiring member 11 before connection and adhesion. From the viewpoint of printing properties and dispensing application properties, the above conductive adhesive is preferably liquid.

As (A) the conductive particles including a metal in which a melting temperature is 200°C or less, particles composed of metals in which a melting temperature is 200°C or less can be used. Further, it is preferred that the conductive particles include no lead. Examples of the metal in which a melting temperature is 200°C or less include alloys comprising one type of metal or two or more types of metal selected from bismuth (Bi), indium (In), zinc (Zn), copper (Cu) and silver (Ag), and tin (Sn). In addition, metals in which a melting temperature is 200°C or less, such as indium (In), may be used alone. Specific examples of the above alloys include Sn48-In52 solder (melting temperature: 117°C), Sn40-Bi56-Zn4 solder (melting temperature: 130°C), Sn42-Bi58 solder (melting temperature: 138°C), Sn42-Bi57-Ag1 solder (melting temperature: 139°C), Sn90-Ag2-Cu0.5-Bi7.5 solder (melting temperature: 189°C), Sn96-Zn8-Bi3 solder (melting temperature: 190°C), and Sn91-Zn9 solder (melting temperature: 197°C). These solders are preferred because they show clear solidification behavior after fusion. These can be used alone, or two or more of these can be used in combination. In addition, for the above conductive particles, two or more different materials can be contained in the conductive adhesive in combination.

The conductive adhesive according to this embodiment may comprises conductive particles including a metal in which a melting temperature is 200°C or less and a metal in which a melting temperature is more than 200°C, or may comprises conductive particles composed of a metal in which a melting temperature is 200°C or less and conductive particles composed of a metal in which a melting temperature is more than 200°C, in a range in which the above-described joining portion is formed. Examples of the metal in which a melting temperature is more than 200°C include alloys composed of one type of metal or two or more types of metals selected from Pt, Au, Ag, Cu, Ni, Pd, Al, Sn, and the like. More specific examples include a Au powder, a Ag powder, a Cu powder, a Ag-plated Cu powder, a SnAg solder powder, and a SnAgCu solder powder. As commercial products, the trade name "MA05K" manufactured by Hitachi Chemical Co., Ltd., and the like can be used.

The average particle diameter of (A) the conductive particles including a metal in which a melting temperature is 200°C or less is not particularly limited, and is preferably 0.1 to 100 µm. If this average particle diameter is less than 0.1 µm, there is a tendency that the viscosity of the conductive adhesive increases and workability decreases. In addition, if the average particle diameter of the conductive particles is more than 100 µm, there is a tendency that printing properties decrease and connection reliability decreases. From the viewpoint of making the printing properties and workability of the conductive adhesive better, this average particle diameter is more preferably 1.0 to 50 µm. Further, from the viewpoint of improving the storage stability of the conductive adhesive and the mounting reliability of a cured product, this average particle diameter is particularly preferably 5.0 to 30 µm.

For the content of the above conductive particles in the conductive adhesive according to this embodiment, it is preferred that the content of the metal in which a melting temperature is 200°C or less is 30 to 95% by mass with respect to the total amount of the conductive adhesive. If the content of the above metal is less than 30% by mass, there is a tendency that the connection structure including the above-described joining portion is less likely to be formed, and it is difficult to ensure conduction between the electrode and the wiring member. On the other hand, if the content of the above metal is more than 95% by mass, there is a tendency that the viscosity of the conductive adhesive increases and workability decreases. In addition, the adhesive component in the conductive adhesive decreases relatively, and therefore, there is a tendency that the mounting reliability of a cured product decreases. The proportion of the metal in which a melting temperature is 200°C or less to the total amount of the conductive adhesive is more preferably 40 to 90% by mass from the viewpoint of improving workability or conductivity, further preferably 50 to 85% by mass from the viewpoint of increasing the mounting reliability of a cured product, and further preferably 60 to 80% by mass from the viewpoint of achieving both temperature cycle resistance and dispensing application properties.

(B) the thermosetting resin has the function of adhering the front electrode 20 or the back electrode 21 to the wiring member 11. In this embodiment, the resin portions 31 reinforcing the peripheral portions of the metal portion 30 in the center of the joining portion 22 are formed by a cured product of the thermosetting resin. Examples of the thermosetting resin include thermosetting organic polymer compounds, such as epoxy resins, acrylic resins, maleimide resins, and cyanate resins, and precursors thereof. Among these, compounds having a polymerizable carbon-carbon double bond in a molecule, typified by acrylic resins and maleimide resins, or epoxy resins are preferred. These thermosetting resins are excellent in heat resistance and adhesiveness, and moreover also excellent in workability because they can also be handled in the state of a liquid when dissolved or dispersed in an organic solvent as required. For the above-described thermosetting resins, one is used alone, or two or more are used in combination.

Examples of a compound having a polymerizable carbon-carbon double bond in a molecule constituting an acrylic resin include monoacrylate compounds, monomethacrylate compounds, diacrylate compounds, and dimethacrylate compounds.

Examples of the monoacrylate compounds include methyl acrylate, ethyl acrylate, propyl acrylate, isopropyl acrylate, n-butyl acrylate, isobutyl acrylate, t-butyl acrylate, amyl acrylate, isoamyl acrylate, hexyl acrylate, heptyl acrylate, octyl acrylate, 2-ethyl hexyl acrylate, nonyl acrylate, decyl acrylate, isodecyl acrylate, lauryl acrylate, tridecyl acrylate, hexadecyl acrylate, stearyl acrylate, isostearyl acrylate, cyclohexyl acrylate, isobomyl acrylate, diethylene glycol acrylate, polyethylene glycol acrylate, polypropylene acrylate, 2-methoxyethyl acrylate, 2- ethoxyethyl acrylate, 2-butoxyethyl acrylate, methoxydiethylene glycol acrylate, methoxypolyethylene glycol acrylate, dicyclopentenyl oxyethyl acrylate, 2- phenoxyethyl acrylate, phenoxydiethylene glycol acrylate, phenoxypolyethylene glycol acrylate, 2-benzoyl oxyethyl acrylate, 2-hydroxy-3-phenoxypropyl acrylate, benzyl acrylate, 2-cyanoethyl acrylate, γ-acryloxyethyl trimethoxysilane, glycidyl acrylate, tetrahydrofurfuryl acrylate, dimethyl aminoethyl acrylate, diethyl aminoethyl acrylate, acryloxyethyl phosphate and acryloxyethylphenyl acid phosphate.

Examples of the monomethacrylate compounds include methyl methacrylate, ethyl methacrylate, propyl methacrylate, isopropyl methacrylate, n-butyl methacrylate, isobutyl methacrylate, t-butyl methacrylate, amyl methacrylate, isoamyl methacrylate, hexyl methacrylate, heptyl methacrylate, octyl methacrylate, 2-ethyl hexyl methacrylate, nonyl methacrylate, decyl methacrylate, isodecyl methacrylate, lauryl methacrylate, tridecyl methacrylate, hexadecyl methacrylate, stearyl methacrylate, isostearyl methacrylate, cyclohexyl methacrylate, isobornyl methacrylate, diethylene glycol methacrylate, polyethylene glycol methacrylate, polypropylene methacrylate, 2-methoxyethyl methacrylate, 2-ethoxyethyl methacrylate, 2-butoxyethyl methacrylate, methoxydiethylene glycol methacrylate, methoxypolyethylene glycol methacrylate, dicyclopentenyl oxyethyl methacrylate, 2-phenoxyethyl methacrylate, phenoxydiethylene glycol methacrylate, phenoxypolyethylene glycol methacrylate, 2-benzoyl oxyethyl methacrylate, 2-hydroxy-3-phenoxypropyl methacrylate, benzyl methacrylate, 2-cyanoethyl methacrylate, γ- methacryloxyethyl trimethoxysilane, glycidyl methacrylate, tetrahydrofurfuryl methacrylate, dimethyl aminoethyl methacrylate, diethyl aminoethyl methacrylate, methacryloxyethyl phosphate and methacryloxy ethyl phenyl acid phosphate.

Examples of the diacrylate compounds include ethylene glycol diacrylate, 1,4-butane diol diacrylate, 1,6-hexane diol diacrylate, 1,9-nonane diol diacrylate, 1,3-butane diol diacrylate, neopentyl glycol diacrylate, diethylene glycol diacrylate, triethylene glycol diacrylate, tetraethylene glycol diacrylate, polyethylene glycol diacrylate, tripropylene glycol diacrylate, polypropylene glycol diacrylate; a reaction product of 1 mole of bisphenol A, bisphenol F or bisphenol AD and 2 moles of glycidyl acrylate; a diacrylate of a polyethylene oxide adduct of bisphenol A, bisphenol F or bisphenol AD; a diacrylate of a polypropylene oxide adduct of bisphenol A, bisphenol F or bisphenol AD; and bis(acryloxypropyl)polydimethylsiloxane, and a bis(acryloxypropyl)methylsiloxane-dimethylsiloxane copolymer.

Examples of the dimethacrylate compounds include ethylene glycol dimethacrylate, 1,4-butane diol dimethacrylate, 1,6-hexane diol dimethacrylate, 1,9-nonane diol dimethacrylate, 1,3-butane diol dimethacrylate, neopentyl glycol dimethacrylate, diethylene glycol dimethacrylate, triethylene glycol dimethacrylate, tetraethylene glycol dimethacrylate, polyethylene glycol dimethacrylate, tripropylene glycol dimethacrylate, polypropylene glycol dimethacrylate; a reaction product of 1 mole of bisphenol A, bisphenol F or bisphenol AD and 2 moles of glycidyl methacrylate; a dimethacrylate of a polyethylene oxide adduct of bisphenol A, bisphenol F or bisphenol AD; a dimethacrylate of a polypropylene oxide adduct of bisphenol F or bisphenol AD; and bis(methacryloxypropyl)polydimethylsiloxane, and a bis(methacryloxypropyl)methylsiloxane-dimethylsiloxane copolymer.

For these compounds having a polymerizable carbon-carbon double bond in a molecule, one is used alone, or two or more are used in combination.

When the conductive adhesive comprises the compound having a polymerizable carbon-carbon double bond in a molecule as the thermosetting resin, it is preferred that the conductive adhesive comprises a radical polymerization initiator. For the radical polymerization intiator, organic peroxides are preferred from the viewpoint of effectively suppressing voids, and the like. In addition, from the viewpoint of improving the curability and viscosity stability of the conductive adhesive, it is preferred that the organic peroxides have a decomposition temperature of 70 to 170°C.

Examples of the radical polymerization initiator include 1,1,3,3-tetramethyl butyl peroxy2-ethyl hexanoate, 1,1-bis (t-butyl peroxy) cyclohexane, 1,1-bis (t-butyl peroxy) cyclododecane, di-t-butyl peroxyisophthalate, t-butyl peroxybenzoate, dicumyl peroxide, t-butyl cumyl peroxide, 2,5-dimethyl-2,5-di (t-butyl peroxy) hexane, 2,5-dimethyl-2,5-di (t-butyl peroxy) 3-hexyne, cumene hydroperoxide. For these, one is used alone, or two or more are used in combination.

The blending proportion of the radical polymerization initiator is preferably 0.01 to 20% by mass, more preferably 0.1 to 10% by mass, and further preferably 0.5 to 5% by mass, with respect to the total amount of the adhesive component other than the conductive particles in the conductive adhesive.

As the epoxy resins, known compounds can be used without particular limitation as long as they are compounds having two or more epoxy groups in one molecule thereof. Examples of such epoxy resins include epoxy resins derived from bisphenol A, bisphenol F, bisphenol AD, or the like, and epichlorohydrin.

For such epoxy resins, commercial epoxy resins are available. Specific examples of the commercial epoxy resins include AER-X8501 (trade name, manufactured by Asahi Chemical Industry Co., Ltd.), R-301 (trade name, manufactured by Japan Epoxy Resin) and YL-980 (trade name, manufactured by Japan Epoxy Resin), which are bisphenol A type epoxy resins, YDF-170 (trade name, manufactured by Tohto Kasei Co., Ltd.) and YL-983 (trade name, manufactured by Japan Epoxy Resin), which are bisphenol F type epoxy resins, R-1710 (trade name, manufactured by Mitsui Petrochemical Industries, Ltd.), which is a bisphenol AD type epoxy resin, N-730S (trade name, manufactured by Dainippon Ink and Chemicals, Incorporated) and Quatrex-2010 (trade name, manufactured by The Dow Chemical Company), which are phenol novolac type epoxy resins, YDCN-702S (trade name, manufactured by Tohto Kasei Co., Ltd.) and EOCN-100 (trade name, manufactured by Nippon Kayaku Co., Ltd.), which are cresol novolac type epoxy resins, EPPN-501 (trade name, manufactured by Nippon Kayaku Co., Ltd.), TACTIX-742 (trade name, manufactured by The Dow Chemical Company), VG-3010 (trade name, manufactured by Mitsui Petrochemical Industries, Ltd.) and 1032S (trade name, manufactured by Japan Epoxy Resin), which are polyfunctional epoxy resins, HP-4032 (trade name, manufactured by Dainippon Ink and Chemicals, Incorporated), which is an epoxy resin having a naphthalene skeleton, EHPE-3150 and CEL-3000 (both are trade names, manufactured by Daicel Chemical Industries, Ltd.), DME-100 (trade name, manufactured by New Japan Chemical Co., Ltd.) and EX-216L (trade name, manufactured by Nagase Chemicals, Ltd.), which are alicyclic epoxy resins, W-100 (trade name, New Japan Chemical Co., Ltd.), which is an aliphatic epoxy resin, ELM-100 (trade name, manufactured by Sumitomo Chemical Co., Ltd.), YH-434L (trade name, manufactured by Tohto Kasei Co., Ltd.), TETRAD-X and TETRAC-C (both are trade names, Mitsubishi Gas Chemical Company, Inc.), and 630 and 630LSD (both are trade names, manufactured by Japan Epoxy Resin), which are amine type epoxy resins, DENACOL EX-201 (trade name, manufactured by Nagase Chemicals, Ltd.), which is a resorcin type epoxy resin, DENACOL EX-211 (trade name, manufactured by Nagase Chemicals, Ltd.), which is a neopentyl glycol type epoxy resin, DENACOL EX-212 (trade name, manufactured by Nagase Chemicals, Ltd.), which is a hexanedinel glycol type epoxy resin, DENACOL EX series (EX-810, 811, 850, 851, 821, 830, 832, 841 and 861 (all are trade names, manufactured by Nagase Chemicals, Ltd.)), which are ethylene-propylene glycol type epoxy resins, and, E-XL-24 and E-XL-3L (both are trade names, manufactured by Mitsui Chemicals, Inc.), which are epoxy resins represented by the following formula (I). Among these epoxy resins, bisphenol A type epoxy resins, bisphenol F type epoxy resins, bisphenol AD type epoxy resins, and amine type epoxy resins, which have a small amount of ionic impurities and are excellent in reactivity, are particularly preferred.

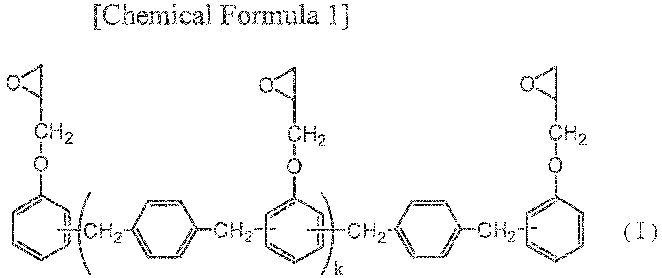

wherein k represents an integer of 1 to 5, in formula (I).

For the above-described epoxy resins, one is used alone, or two or more are used in combination.

When the conductive adhesive comprises the epoxy resin as the thermosetting resin, the conductive adhesive may further comprise an epoxy compound having only one epoxy group in one molecule as a reactive diluent. Such an epoxy compound is available as a commercial product. Specific examples of the commercial product include PGE (trade name, manufactured by Nippon Kayaku Co., Ltd.), PP-101 (trade name, manufactured by Tohto Kasei Co., Ltd.), ED-502, ED-509, and ED-509S (trade names, manufactured by ASAHI DENKA Co., Ltd.), YED-122 (trade name, manufactured by Yuka Shell Epoxy), KBM-403 (trade name, manufactured by Shin-Etsu Chemical Co., Ltd.), and TSL-8350, TSL-8355, and TSL-9905 (trade name, manufactured by Toshiba Silicone Corporation). For these, one is used alone, or two or more are used in combination.

The blending proportion of the reactive diluent may be in a range that does not inhibit the effect of the present invention, and is preferably 0 to 30% by mass with respect to the total amount of the above epoxy resin.

When the conductive adhesive comprises the epoxy resin as the thermosetting resin, the conductive adhesive preferably further comprises a curing agent therefor, and more preferably contains a curing accelerator for improving curability, in addition to the curing agent.

The curing agent is not particularly limited as long as it is a conventionally used one, and commercial ones are available. Examples of commercial curing agents include H-1 (trade name, manufactured by Meiwa Plastic Industries, Ltd.) and VR-9300 (trade name, manufactured by Mitsui Toatsu Chemicals, Inc.), which are phenol novolac resins, XL-225 (trade name, manufactured by Mitsui Toatsu Chemicals, Inc.), which is a phenol aralkyl resin, MTPC (trade name, manufactured by Honshu Chemical Industry Co., Ltd.), which is a p-cresol novolac resin represented by the following formula (II), AL-VR-9300 (trade name, manufactured by Mitsui Toatsu Chemicals, Inc.), which is an allylated phenol novolac resin, and PP-700-300 (trade name, manufactured by Nippon Petrochemicals Co., Ltd.), which is a special phenolic resin represented by the following formula (III).

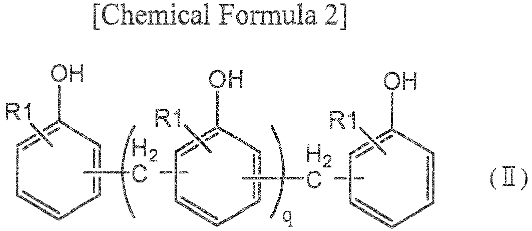

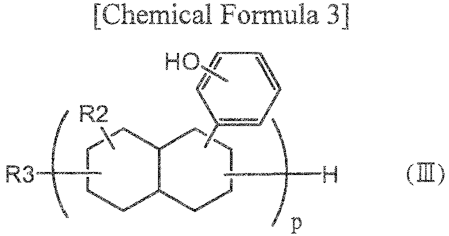

In formula (II), R1 each independently represents a monovalent hydrocarbon group, preferably a methyl group or an allyl group, and q represents an integer of 1 to 5. In addition, in formula (III), R2 represents an alkyl group, preferably a methyl group or an ethyl group, R3 represents a hydrogen atom or a monovalent hydrocarbon group, and p represents an integer of 2 to 4.

The blending proportion of the curing agent is preferably a proportion in which the total amount of reaction active groups in the curing agent is 0.2 to 1.2 equivalent, more preferably 0.4 to 1.0 equivalent, and further preferably 0.5 to 1.0 equivalent, with respect to 1.0 equivalent of epoxy groups of the epoxy resin. If the reaction active groups are less than 0.2 equivalent, there is a tendency that the reflow crack resistance of the conductive adhesive decreases, and if the reaction active groups are more than 1.2 equivalent, there is a tendency that the viscosity of the conductive adhesive increases and workability decreases. The above reaction active groups mean substituents having reaction activity with the epoxy resin, and examples of the reaction active groups include phenolic hydroxyl groups.

In addition, the above curing accelerator is not particularly limited as long as it is one conventionally used as a curing accelerator, such as dicyandiamide, and commercial products are available. Examples of the commercial products include ADH, PDH, and SDH (all are trade names, manufactured by JAPAN HYDRAZINE COMPANY, INC.), which are dibasic acid dihydrazides represented by the following formula (IV), and Novacure (trade name, manufactured by Asahi Chemical Industry Co., Ltd.), which is a microcapsule type curing agent composed of a reaction product of an epoxy resin and an amine compound. For these curing accelerators, one is used alone, or two or more are used in combination.

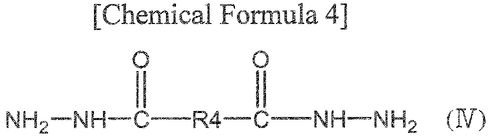

wherein R4 represents a divalent aromatic group or a straight chain or branched chain alkylene group having 1 to 12 carbon atoms, preferably a m-phenylene group or a p-phenylene group.

The blending proportion of the above curing accelerator is preferably 0.01 to 90 parts by mass, more preferably 0.1 to 50 parts by mass, with respect to 100 parts by mass of the epoxy resin. If this blending proportion of the curing accelerator is less than 0.01 parts by mass, there is a tendency that curability decreases, and if this blending proportion of the curing accelerator is more than 90 parts by mass, there is a tendency that viscosity increases, and workability in handling the conductive adhesive decreases.

In addition, as commercial curing accelerators, in addition to/instead of those described above, for example, EMZ.K and TPPK (both are trade names, manufactured by HOKKO CHEMICAL INDUSTRY CO., LTD.), which are organic boron salt compounds, DBU, U-CAT102, 106, 830, 840, and 5002 (all are trade names, manufactured by San-Apro Ltd.), which are tertiary amines or salts thereof, and CUREZOL, 2PZ-CN, 2P4MHZ, C17Z, 2PZ-OK, 2PZ-CNS, and C11Z-CNS (all are trade names, manufactured by SHIKOKU CHEMICALS CORPORATION), which are imidazoles, may be used.

The blending proportion of these curing accelerators is preferably 20 parts by mass or less with respect to 100 parts by mass of the epoxy resin.

In addition, for the curing agent and the curing accelerator, one may be used alone, or two or more may be used in combination.

(C) the flux activator is a compound having the function of removing oxide films formed on the surfaces of the conductive particles having a metal in which a melting temperature is 200°C or less. For the flux activator, known compounds can be used without particular limitation as long as they are compounds that do not inhibit the curing reaction of (B) the thermosetting resin. Examples of such compounds include rosin-based resins, and compounds containing a carboxyl group, a phenolic hydroxyl group or a hydroxyl group in a molecule. Compounds containing a carboxyl group or a hydroxyl group in a molecule are preferred, and aliphatic dihydroxycarboxylic acids are particularly preferred, because they show good flux activity and show reactivity with the epoxy resin used as (B) the thermosetting resin. Specifically, compounds represented by the following formula (V) or tartaric acid is preferred.

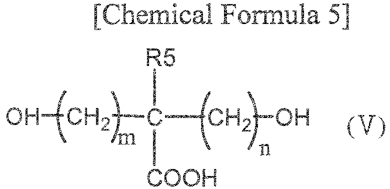

Here, in formula (V), R5 represents an alkyl group having 1 to 5 carbon atoms, which may be substituted. From the viewpoint of more effectively exhibiting the above-described effect according to the present invention, R5 is preferably a propyl group, a butyl group, or a pentyl group. In addition, n and m each independently represent an integer of 0 to 5. From the viewpoint of more effectively exhibiting the above-described effect according to the present invention, it is preferred that n is 0 and m is 1, or n and m are both 1, and it is more preferred that n and m are both 1.

Examples of the compounds represented by the above formula (V) include 2,2-bishydroxymethylpropionic acid, 2,2-bishydroxymethylbutanoic acid, and 2,2-bishydroxymethylpentanoic acid.

The content of the flux activator is preferably 0.5 to 20 parts by mass with respect to 100 parts by mass of the total amount of the metal in which a melting temperature is 200°C or less, from the viewpoint of more effectively exhibiting the above-described effect according to the present invention. Further, the content of the flux activator is more preferably 1.0 to 10 parts by mass from the viewpoint of storage stability and conductivity. If the content of the flux activator is less than 0.5 parts by mass, there is a tendency that the melting properties of the metal decrease and conductivity decreases, and if the content of the flux activator is more than 20 parts by mass, there is a tendency that storage stability and printing properties decrease.

The conductive adhesive according to this embodiment may comprise, in addition to the above-described components, one or more additives selected from the group consisting of flexible agents for stress relaxation, diluents for workability improvement, adhesion-improving agents, wettability-improving agents, and defoaming agents, as required. In addition, the conductive adhesive according to this embodiment may comprise, in addition to these components, various additives in a range that does not inhibit the effect of the present invention.

Examples of the flexible agents include liquid polybutadiene (the trade names "CTBN-1300×31" and "CTBN-1300×9," manufactured by Ube Industries, Ltd., and the trade name "NISSO-PB-C-2000," manufactured by Nippon Soda Co., Ltd.). The content of the flexible agent is generally preferably 0 to 500 parts by mass with respect to 100 parts by mass of the total amount of the thermosetting resin.

The conductive adhesive may comprise a coupling agent, such as a silane coupling agent or a titanium coupling agent, for the purpose of adhesion improvement. Examples of the silane coupling agent include the trade name "KBM-573," manufactured by Shin-Etsu Chemical Co., Ltd. In addition, for the purpose of wettability improvement, an anionic surfactant, a fluorine-based surfactant, or the like may be contained in the conductive adhesive. Further, the conductive adhesive may contain a silicone oil or the like as a defoaming agent, and may contain an aliphatic ester, such as castor wax, as a thixotropy imparting agent. For the above adhesion-improving agents, wettability-improving agents, and defoaming agents, one is used alone, or two or more are used in combination. It is preferred that 0.1 to 10% by mass of these are contained with respect to the total amount of the conductive adhesive.

In order to make workability during the making of the conductive adhesive and application workability during the use of the conductive adhesive better, a diluent can be added to the conductive adhesive, as required. As such a diluent, organic solvents having a relatively high boiling temperature, such as butyl cellosolve, carbitol, butyl cellosolve acetate, carbitol acetate, dipropylene glycol monomethyl ether, ethylene glycol diethyl ether, and α-terpineol, are preferred. It is preferred that 0.1 to 30% by mass of this diluent is contained with respect to the total amount of the conductive adhesive.

The conductive adhesive may contain a filler. Examples of the filler include polymer particles of acrylic rubbers, polystyrene, and the like, and inorganic particles of diamond, boron nitride, aluminum nitride, alumina, silica, and the like. For these fillers, one may be used alone, or two or more may be mixed and used.

For the above-described components, any of those illustrated in respective components may be combined.

The conductive adhesive according to this embodiment is obtained as a pasty one in which the above-described components are uniformly dispersed, by subjecting the components to mixing, dissolution, disaggregation, kneading or dispersion, with heating as required, at a time or in a plurality of batches. Examples of a dispersion and dissolution apparatus used at this time include known stirrers, grinders, three-roll mills, and planetary mixers.

In the solar cell module in this embodiment, the resin portions 31 may be formed by an adhesive made of a resin other than the above-described thermosetting resins. Examples of other adhesives made of resins include thermoplastic resins. Examples of the thermoplastic resins include respective single systems of polyimide resins, polyamide resins, polyether resins, polyurethane resins, polyacrylates, phenoxy resins, and phenolic resins, and copolymers of two or more types of the above thermoplastic resins.

Next, a method for manufacturing the solar cell module of the present invention will be described using the drawings.

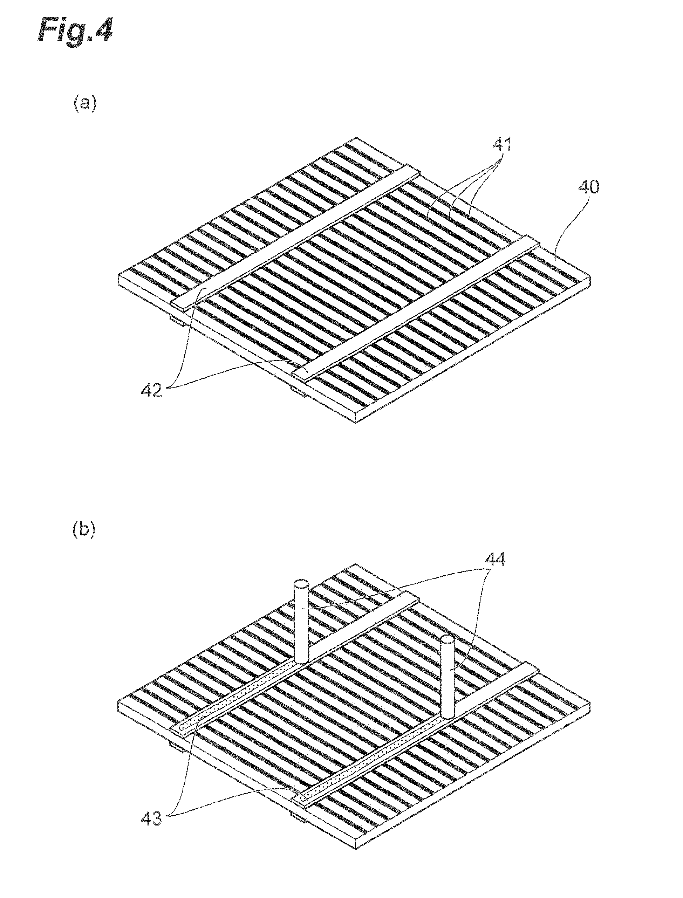

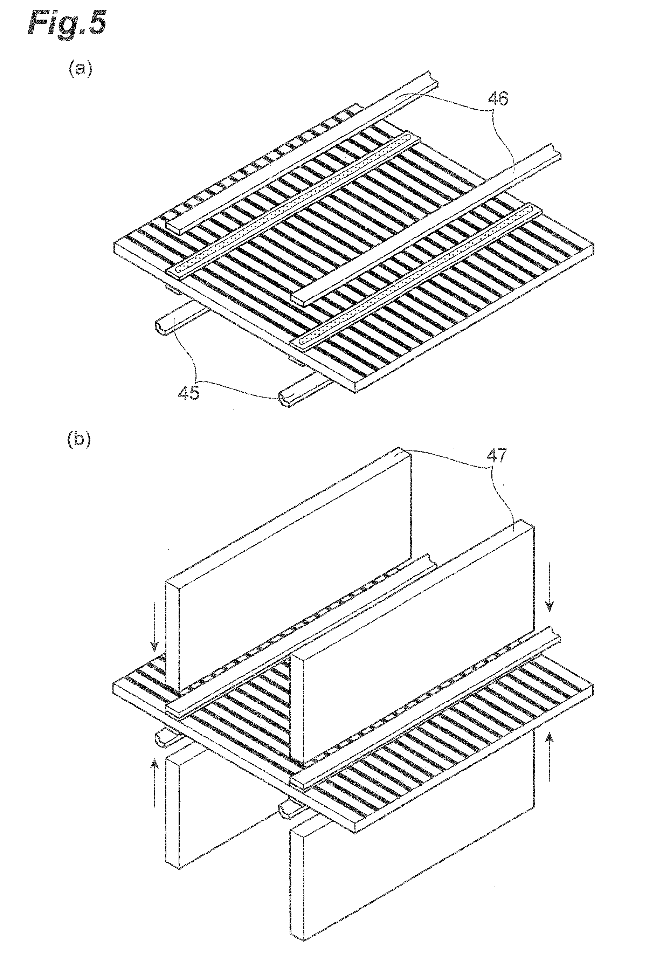

Figure 4 and Figure 5 are schematic diagrams for explaining one embodiment of the method for manufacturing the solar cell module of the present invention. In the method according to this embodiment, first, solar cells to be connected are prepared. A solar cell 40 shown in Figure 4(a) has front electrodes 42 having a width of 0.5 to 2.5 mm wired in a direction orthogonal to current collection wires 41 having a width of 0.03 to 0.4 mm, with a surface on which the current collection wires lie used as an upper surface. Next, as shown in Figure 4(b), a conductive adhesive 43 is applied onto the front electrodes 42 using dispensers 44. The conductive adhesive is also similarly applied by dispensers to back electrodes provided on the back side of the solar cell, and the conductive adhesive may be applied simultaneously with application to the above front electrodes, or after the solar cell in which the conductive adhesive is applied to the front electrodes is reversed. This conductive adhesive application step is not limited to the above dispensing method, and may be a screen printing method or a transfer method.

Next, as shown in Figure 5(a), wiring members 45 and wiring members 46 are mounted on the back side and the front side, respectively. For the wiring members 45 and 46, in addition to conventionally used Cu wires and solder-plated wires, a film-shaped wiring board in which metal wiring is formed on a plastic substrate may be used. Then, as shown in Figure 5(b), the mounted wiring members are thermocompression-bonded by thermocompression bonding machines 47 to connect the wiring members to the electrodes of the solar cell by the conductive adhesive. Thermocompression bonding temperature at this time is not less than the melting temperature of conductive particles contained in the conductive adhesive. In this embodiment, 150 to 180°C is preferred. For pressure, 0.01 to 1.0 MPa is preferred. Compression bonding time can be 1 to 30 sec. This step of connecting the wiring members to the electrodes of the solar cell is not limited to the above method using the thermocompression bonding machines, and hot air or a laminator may be used. By similarly performing the connection of the electrodes of a solar cell disposed next to the above solar cell to the wiring members as in the above, a solar cell-coupling structure as shown in Figure 1, that is, a connection structure in which a plurality of solar cells each having electrodes on both surfaces are electrically connected to each other by wiring members, can be fabricated. In this embodiment, the above-described joining portions 22 are formed by the above connection step.

Then, by laminating a sealing resin using an ethylene-vinyl acetate-copolymerized resin (EVA) or polyvinyl butyral and a glass substrate on the light-receiving surface side of the solar cells, laminating the above sealing resin and a protective film referred to as a back sheet on a back side, and then heating these by a laminator, a solar cell module can be fabricated.

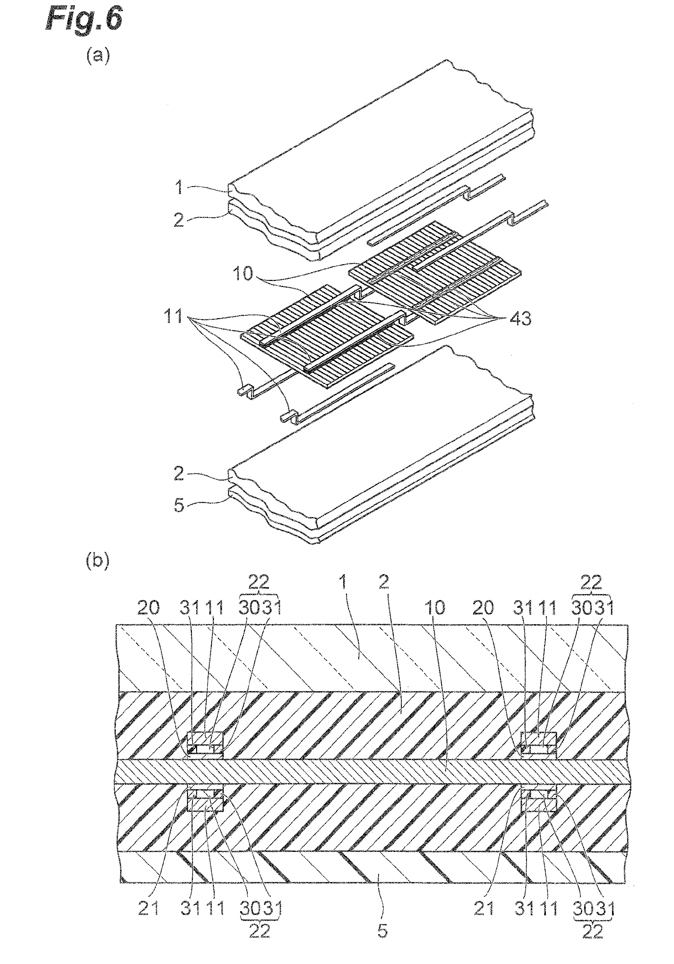

Examples of another method for manufacturing the solar cell module of the present invention include a method of performing the adhesion of the electrodes of solar cells to wiring members, and the sealing of the solar cells, together. Figure 6 is a schematic diagram for explaining another manufacturing method.

As shown in Figure 6 (a), a plurality of solar cells 10 in which a conductive adhesive 43 is applied to front electrodes and back electrodes are prepared, and one ends of wiring members 11 are disposed opposed to the front electrodes of the solar cell 10, and the other ends are disposed opposed to the back electrodes of another solar cell 10, with the applied conductive adhesive 43 sandwiched between them. Further, a sealing resin 2 is disposed on the light-receiving surface side of the solar cells, and glass 1 is disposed on this sealing resin 2. On the other hand, a sealing resin 2 is disposed on an opposite side (back side) to the light-receiving surfaces of the solar cells, and a protective film 5 is disposed on this sealing resin 2. By heating in this state the whole to a temperature at which conductive particles in the conductive adhesive melt, while applying pressure as required, the wiring members 11 are electrically connected and adhered to the front electrodes and the back electrodes, and simultaneously, the solar cells are sealed with the sealing resin. The conditions of the heating at this time are, for example, 1 second to 60 seconds at 150 to 180°C. The condition of pressure is, for example, 0.01 to 1.0 MPa.

Thus, the solar cell module according to the present invention that comprises a connection structure in which joining portions 22 composed of metal portion 30 and resin portions 31 are formed as shown in Figure 6 (b), and a plurality of solar cells each having electrodes on both surfaces are electrically connected to each other by wiring members is manufactured.

### Examples

The present invention will be described in more detail below by examples, but the present invention is not limited to these examples.

### (Example 1)

### [Preparation of Conductive Adhesive]

26.7 Parts by mass of YDF-170 (the trade name of a bisphenol F type epoxy resin, manufactured by Tohto Kasei Co., Ltd., epoxy equivalent = 170), 1.2 parts by mass of 2P4MZ (the trade name of an imidazole compound, manufactured by SHIKOKU CHEMICALS CORPORATION), and 2.1 parts by mass of BHPA (2,2-bishydroxymethylpropionic acid) were mixed, and the mixture was passed through a three-roll mill three times to prepare an adhesive component.

Next, 70 parts by mass of Sn42-Bi58 particles (average particle diameter: 20 µm, melting temperature: 138°C), which were conductive particles, were added to and mixed with 30 parts by mass of the above-described adhesive component. The obtained mixture was passed through a three-roll mill three times, and then subjected to defoaming treatment at 500 Pa or less for 10 minutes using a vacuum stirring grinder to obtain a conductive adhesive.

### [Fabrication of Solar Cells with Tab Wires]

The liquid conductive adhesive obtained above was applied onto front electrodes (material: a silver glass paste, 2 mm × 125 mm) formed on the light-receiving surface of a solar cell (125 mm × 125 mm, thickness: 310 µm) with a weight per unit length of 0.2 mg/mm using dispensers. Then, solder-coated tab wires (trade name: A-TPS, manufactured by Hitachi Cable, Ltd.) as wiring members were disposed on the electrodes to which the conductive adhesive was applied, and thermocompression-bonded under the conditions of a temperature of 150°C, a load of 0.5 MPa, and a holding time of 10 sec, using thermocompression bonding machines. Similar treatment was performed for electrodes on the back of the solar cell, and 10 sets of solar cells with tab wires were fabricated.

### [Evaluation of Cell Breakage Rate]

The appearance of the above solar cells with tab wires was visually observed, the presence or absence of fractures and cracks was checked, and their breakage rate was evaluated. In tables, a figure on the left side represents the number of cells in which breakage was seen.

### [Checking of Joining Portion]

An epoxy resin was cast on one set of the solar cell with tab wires obtained above, this was cut at a surface orthogonal to a direction in which the tab wires extended, and the cross section of the joining portion of the electrode of the solar cell and the tab wire was checked. Cross sections were checked in five places. When the electrode of the solar cell and the tab wire were connected by a melt of the conductive particles, the proportion of metal portion connection width to tab wire width (the metal portion/the tab wire) was measured. When the electrode of the solar cell and the tab wire were adhered to each other by the resin, the proportion of the width of portions adhered by the resin to tab wire width (the resin portions/the tab wire) was measured.

### [Fabrication of Solar Cell Module]

The solar cells with tab wires fabricated above were prepared, and a sealing resin (trade name: SOLAR EVA SC50B, manufactured by Mitsui Chemicals Fabro Inc.) and a protective film (trade name: KOBATECH PV manufactured by KOBAYASHI & CO., LTD.) were laminated on the back side of the solar cells, and a sealing resin (SOLAR EVA SC50B, manufactured by Mitsui Chemicals Fabro Inc.) and glass (200 × 200 × 3 mm) were laminated on the light-receiving surface side of the solar cells. The thus obtained laminate was mounted so that the glass was in contact with the hot plate side of a vacuum laminator (trade name: LM-50×50-S, manufactured by NPC Incorporated), and subjected to evacuation for 5 minutes, and then, a vacuum in the upper portion of the vacuum laminator was released, and the laminate was heated under a pressure of 1 atm at 160°C for 10 minutes to fabricate a solar cell module.

### [Temperature Cycle Test]

The IV curve of the obtained solar cell module was measured using a solar simulator (trade name: WXS-155S-10, manufactured by WACOM ELECTRIC CO., LTD., AM: 1.5 G), and a fill factor (hereinafter abbreviated as F.F) was derived, and this was taken as initial F.F (0 h). Next, a temperature cycle test in which -55°C for 30 minutes and 125°C for 30 minutes was taken as 1 cycle and this was repeated for 1000 cycles was performed on this solar cell module. The F.F of the solar cell module after this temperature cycle test was measured, and this was taken as F.F (1000 h). The rate (ΔF.F) of change in F.F before and after the temperature cycle test was obtained from the formula of [F.F (1000 h) × 100/F.F (0 h)], and this was used as an evaluation indicator. Generally, when the value of ΔF.F is 95% or more, it is determined that connection reliability is good.

### (Examples 2 to 9)

A conductive adhesive was prepared as in Example 1 except that a composition shown in Table 1 was used. Then, solar cells with tab wires were fabricated as in Example 1 except that the obtained conductive adhesive was used, and the evaluation of the cell breakage rate and the checking of the joining portion were performed. However, in Example 7, the temperature of the thermocompression bonding of the electrodes and the wiring members was 170°C.

Further, a solar cell module was fabricated as in Example 1 except that the obtained solar cells with tab wires were used, and ΔF.F before and after the temperature cycle test was measured.

The details of materials shown in Table 1 were as follows. In addition, the unit of the blending proportion of the materials in Table 1 was parts by mass.
YDF-170: a bisphenol F type epoxy resin, a trade name manufactured by Tohto Kasei Co., Ltd.
TETRAD-X: an amine type epoxy resin, a trade name manufactured by Mitsubishi Gas Chemical Company, Inc.
EP-828: EPIKOTE 828, a trade name manufactured by Japan Epoxy Resin.
2P4MZ: an imidazole compound, a trade name manufactured by SHIKOKU CHEMICALS CORPORATION.
BHPA: 2,2-bishydroxymethylpropionic acid.
2,5-DEAD: 2,5-diethyladipic acid.
Sn42-Bi58: Sn42-Bi58 solder particles, average particle diameter: 20 µm, melting temperature: 138°C.
Sn40-Bi56-Zn4: Sn40-Bi56-Zn4 solder particles, average particle diameter: 20 µm, melting temperature: 130°C.
MA05K: a Ag-plated Cu powder, a trade name manufactured by Hitachi Chemical Co., Ltd.

### (Comparative Example 1)

SnAgCu solder-coated tab wires (trade name: A-TPS, manufactured by Hitachi Cable, Ltd.) as wiring members were disposed on front electrodes (material: a silver glass paste, 2 mm × 125 mm) formed on the light-receiving surface of a solar cell (125 mm × 125 mm, thickness: 310 µm), and thermocompression-bonded under the conditions of a temperature of 260°C, a load of 0.5 MPa, and a holding time of 10 sec, using thermocompression bonding machines. Similar treatment was performed for electrodes on the back, and 10 sets of solar cells with tab wires were fabricated.

The evaluation of the cell breakage rate and the checking of the joining portion were performed as in Example 1 for the solar cells with tab wires.

A solar cell module was fabricated as in Example 1 except that the solar cells with tab wires obtained above were used, and its ΔF.F before and after the temperature cycle test was measured.

### (Comparative Example 2)

Solar cells with tab wires were fabricated as in Example 1 except that instead of the conductive adhesive, Sn42Bi58 cream solder (TLF-401-11, manufactured by Tamura Corporation) was used, and the evaluation of the cell breakage rate and the checking of the joining portion were performed.

A solar cell module was fabricated as in Example 1 except that the solar cells with tab wires obtained above were used, and its ΔF.F before and after the temperature cycle test was measured.

### (Comparative Example 3)

A conductive adhesive was prepared as in the method described in Preparation of Conductive Adhesive in Example 1 except that 27.9 parts by mass of the thermosetting resins of Example 1 shown in Table 1 were blended with respect to 100 parts by mass of the total amount of the conductive adhesive, and 72.1 parts by mass of a silver powder (TCG-1, a trade name manufactured by Tokuriki Chemical Research Co., Ltd.) as conductive particles was blended with respect to 100 parts by mass of the total amount of the conductive adhesive. Solar cells with tab wires were fabricated as in Example 1 except that this conductive adhesive was used, and the evaluation of the cell breakage rate and the checking of the joining portion were performed.

A solar cell module was fabricated as in Example 1 except that the solar cells with tab wires obtained above were used, and its ΔF.F before and after the temperature cycle test was measured.

**[Table 1]**

| Items | | Example 1 | Example 2 | Example 3 | Example 4 | Example 5 | Example 6 | Example 7 | Example 8 | Example 9 |
|---|---|---|---|---|---|---|---|---|---|---|
| Thermosetting resins | YDF-170 | 26.7 | - | 26.7 | - | 26.7 | 26.7 | 26.7 | 8.9 | 44.5 |
| | TETRAD-X | - | 26.7 | - | - | - | - | - | - | - |
| | EP-828 | - | - | - | 26.7 | - | - | - | - | - |
| | 2P4MZ | 1.2 | 1.2 | 1.2 | 1.2 | 1.2 | 1.2 | 1.2 | 0.4 | 2.0 |
| Flux activators | BHPA | 2.1 | 2.1 | - | - | 2.1 | 2.1 | 2.1 | 0.7 | 3.5 |
| | 2,5-DEAD | - | - | 2.1 | 2.1 | - | - | - | - | - |
| Conductive particles | Sn42-Bi58 | 70 | 70 | 70 | 70 | - | 60 | 70 | 90 | 50 |
| | Sn40-Bi56-Zn4 | - | - | - | - | 70 | - | - | | - |
| | MA-05K | - | - | - | - | - | 10 | - | - | - |
| Connection temperature (°C) | | 150 | 150 | 150 | 150 | 150 | 150 | 170 | 150 | 150 |
| Cell breakage rate | | 0/10 | 0/10 | 0/10 | 0/10 | 0/10 | 0/10 | 0/10 | 0/10 | 0/10 |
| Metal portion/tab wire (%) | | 21 | 25 | 24 | 24 | 23 | 20 | 24 | 55 | 10 |
| Resin portions/tab wire (%) | | 79 | 75 | 76 | 76 | 77 | 80 | 76 | 45 | 90 |
| ΔF.F(%) | | 98.6 | 97.4 | 97.5 | 95.5 | 97.3 | 96.6 | 97.1 | 97.8 | 95.9 |

**[Table 2]**

| Items | | Comparative Example 1 | Comparitive Example 2 | Comparative Example 3 |
|---|---|---|---|---|
| Connection materials | SnAgCu solder plating | Used | - | - |
| | Sn42Bi58 cream solder | - | Used | - |
| | Silver powder-containing conductive adhesive | | | Used |
| Characteristics | Connection temperature (°C) | 270 | 150 | 150 |
| | Cell breakage rate | 3/10 | 0/10 | 0/10 |
| | Metal portion/tab wire (%) | 100 | 100 | 0 |
| | Resin portions/tab wire (%) | 0 | 0 | 100 |
| | ΔF.F(%) | 96.5 | 90.2 | 58.2 |

In all of the solar cell modules of Examples 1 to 9 that had a metal portion prepared by the melting of a metal having a melting temperature of 200°C or less, electrically connecting the electrode to the wiring member, and resin portions adhering the electrode to the wiring member, the cells did not break during connection, and the ΔF.F before and after the temperature cycle test was sufficiently high, and it was confirmed that the solar cell modules had good reliability.

On the other hand, in the solar cells with tab wires in Comparative Example 1 in which wiring members provided with Sn-Ag-Cu solder plating were used and connections were made at 270°C, the breakage of the cells occurred, and yield decreased. The solar cell module of Comparative Example 2 in which connections were made using a cream solder composed of Sn42-Bi58 and a flux had no resin portions, and the ΔF.F before and after the temperature cycle test decreased. The solar cell module of Comparative Example 3 fabricated using a conductive adhesive composed of a silver filler and an epoxy resin composition had no metal portion prepared by the melting of a metal, and the ΔF.F before and after the temperature cycle test decreased.

### Reference Signs List

### Reference Signs List

1 ... glass, 2 ... sealing resin, 5 ... protective film, 10 ... solar cell, 11 ... wiring member, 20 ... front electrode, 21 ... back electrode, 22 ... joining portion, 23 ... EVA, 30 ... metal portion, 31 ... resin portion, 40 ... solar cell, 41 ... current collection wire, 42 ... front electrode, 43 ... conductive adhesive, 44 ... dispenser, 45 ... wiring member, 46 ... wiring member, 47 ... thermocompression bonding machine.

## Claims

1. A solar cell module comprising a connection structure in which a plurality of solar cells each having electrodes on both surfaces are electrically connected to each other by a wiring member, wherein
the connection structure includes a metal portion prepared by melting of a metal having a melting temperature of 200°C or less, electrically connecting the electrode to the wiring member, and a resin portion adhering the electrode to the wiring member.

2. The solar cell module according to claim 1, wherein the wiring member is strip-shaped, and when the metal portion and the resin portion are viewed in a cross section orthogonal to a direction in which the wiring member extends, the metal portion is positioned to connect a central portion of the wiring member to a central portion of the electrode, and the resin portion is positioned to adhere an outside of the central portion of the wiring member to an outside of the central portion of the electrode.

3. The solar cell module according to claim 1 or 2, wherein the metal portion and the resin portion are formed by heating a conductive adhesive comprising (A) conductive particles comprising a metal having a melting temperature of 200°C or less, (B) a thermosetting resin, and (C) a flux activator, at a temperature at which the conductive particles melt, in a state in which the conductive adhesive is interposed between the electrode and the wiring member before connection and adhesion.

4. The solar cell module according to claim 3, wherein the metal portion and the resin portion are formed by performing the heating while applying pressure to the electrode and the wiring member before connection and adhesion in a direction in which the electrode and the wiring member are opposed to each other.
